# EUROPEAN PATENT APPLICATION

(11) **EP 0 973 258 A2**
(43) Date of publication of application: **19.01.2000**
(21) Application number: 99303715.9
(22) Date of filing: 12.05.1999
(51) Int. Cl.: H03K 3/0233

(54) **Threshold crossing discrimination for oscillatory signals**

(30) Priority: 17.07.1998 GB 9815436
(71) Applicant: FORD MOTOR COMPANY LIMITED, Brentwood Essex (GB); FORD-WERKE AKTIENGESELLSCHAFT, 50735 Köln (DE); Groupe Ford France S.A., 92506 Rueil Malmaison Cedex (FR)
(72) Inventor: Garrard, Michael Robert, Chelmsford, Essex CM1 4HF (GB)
(74) Representative: Messulam, Alec Moses

(57) **Abstract**

The present invention relates to an apparatus for and a method of using hysteresis (43) in an electronic circuit to discriminate in the presence of noise, threshold crossings (67,68,69) of an oscillating signal (40). An oscillating signal (40) is supplied to a comparator circuit having a pair of inputs. An output of the circuit switches between high and low upon a threshold crossing (67,68,69) at the inputs. The circuit provides hysteresis (43) so that once the comparator has switched the output does not fluctuate owing to the noise. One or both of the inputs incorporates the hysteresis. The hysteresis (43) upon switching of the comparator rises (48,148) alternately to a maximum positive magnitude (47) and a maximum negative magnitude (147) in alternate half cycles (51,151;59), and then decays (49,149) in magnitude, the hysteresis (43) on one half cycle (51,151) decaying (49) at a rate that would take the hysteresis (43) to a first limit level (41) and the hysteresis (43) on an alternate half cycle (59) decaying (149,) at a rate that would take the hysteresis (43) to a second limit level (55). The limit levels (41,55) are shifted either both positively or both negatively with respect to the mean level (44) of the oscillating signal (40), and the circuit comprises means to limit (61) the decay in the hysteresis (43) during half cycles (59) in which the hysteresis (43) is of the opposite sign to that of the limit levels (41,55).

## Description

The present invention relates to an apparatus for and a method of using hysteresis in an electronic circuit to discriminate in the presence of noise, threshold crossings of an oscillating signal.

In many applications, it is necessary to detect threshold crossings of an oscillatory signal, often a sinusoidal signal, on which noise is superimposed. The threshold can, for example, be at or close to a mean level of zero volts about which the signal swings symmetrically. Noise will result in timing jitter on the detected threshold crossings. It is also possible for noise to result in false threshold crossing, for example when the noise momentarily brings a falling signal back up across the threshold, or vice versa.

One common application where this is a problem, is in the detection of crank position in a motor vehicle, where a signal, typically from a variable reluctance sensor detects the passing of metal teeth on a crank shaft. Such signals are used, for example, to schedule fuel injection or spark events. The automotive electrical environment is inherently noisy, particularly during start-up of the engine, and there is the added problem of having to deal with a crank signal that varies over a wide amplitude and frequency range, for example 150 mV at 15Hz up to 400 V at 5 kHz. Furthermore, the amplitude range will vary between vehicles, for example by up to 500 %, owing to variations in the physical gap between the crank sensor and toothed wheel. This places a demanding requirement on interface electronics to accept valid signals and yet maintain a high level of noise immunity, since the amplitude and frequency of interference often falls within the valid range of signals.

Prior art crank signal interface circuits have made use of positive feedback to apply hysteresis to the incoming signal. This unfortunately introduces a phase delay whereby the transition from the output of the interface circuit lags the transition on the input. Because of the way hysteresis is normally implemented, with a gradual decay of a hysteresis signal over the time of a half cycle of the waveform, the phase delay can also be variable depending on the frequency of the signal and the speed of the engine. For variable reluctance sensors, this is particularly significant, because the zero crossing of the signal is the point at which the sensor accurately locates the object it is sensing, for example the centre of a tooth or gap between teeth. The result is a phase delay or inaccuracy of the sensing system, leading to inaccuracy in engine control, for example spark or injection timing.

Often, one half cycle of the crank signal is more prone to noise than the other half cycle. This is because it is common practice to have at least one identifiable position with a missing tooth on a toothed wheel so that the top dead centre position of the engine can be identified. This results in an elongated "half" cycle in which the crank signal, for example on a rising edge, has a lower slope, during which threshold detection is more prone to noise.

One prior art approach to dealing with these problems is to apply hysteresis to only one edge of the sensor signal, for example, the rising edge, and apply no hysteresis to the falling edge. In other words, hysteresis is used during only one half cycle of the oscillatory signal. This removes the phase delay from the transition of interest for timing whilst allowing discrimination against noise on the half cycle extended by the missing tooth, but still leaves the problem that noise when the signal is small can result in multiple false transitions at threshold.

Another approach is disclosed in US 4,549,099, in which a hysteresis signal is applied on both half cycles. On one half cycle the decay time is sufficiently long that the hysteresis signal does not reach a mean level of the signal. On the other half cycle, the hysteresis decays very rapidly to reach the mean signal level well before the next threshold crossing is due. This avoids a phase delay on the threshold crossing at the end of the half cycle for which the hysteresis is fully decayed, but means that the hysteresis provides noise discrimination only for a relatively short time following the start of this half cycle.

It is an object of the present invention to provide a more convenient and reliable apparatus for and a method of using hysteresis in an electronic circuit to discriminate in the presence of noise, threshold crossings of an oscillating signal.

Accordingly, the invention provides an electronic circuit for discriminating in the presence of noise, threshold crossings of an oscillating signal having a mean level, the mean level defining alternating positive-going half cycles and negative-going half cycles, the circuit comprising: an input for said oscillating signal; a comparator means having a pair of comparator inputs; an output from the comparator means that switches between high and low upon a threshold crossing; means for providing hysteresis so that once the comparator means has switched between high and low said output does not fluctuate between high and low owing to the noise; wherein the pair of comparator inputs are each provided with an input signal, one or both of said signals incorporating said hysteresis and being at least partially dependent on the oscillating signal, the difference between said input signals defining a threshold level at which the comparator means switches, the hysteresis upon switching of the comparator means rising alternately to a maximum positive magnitude and a maximum negative magnitude in alternate half cycles, and then decaying thereafter in magnitude, the hysteresis on one half cycle decaying at a rate that would take the hysteresis to a first limit level and the hysteresis on an alternate half cycle decaying at a rate that would take the hysteresis to a second limit level, characterised in that the limit levels are shifted either both positively or both negatively with respect to the mean level of the oscillating signal, and in that the circuit comprises means to limit the decay in the hysteresis during half cycles in which the hysteresis is of the opposite sign to that of the limit levels.

The oscillating signal may be an essentially sinusoidal signal, in which case the half cycle may last for half of the period between sinusoidal pulses. However, the term "half cycle" also applies to other less regular or non-sinusoidal signals where there is an identifiable series of pulses covering a full cycle.

Hysteresis for a full first half cycle is therefore provided, whilst during a subsequent second half cycle hysteresis is removed prior to an expected crossing of a threshold, and then reapplied as soon as the threshold crossing is detected. The detection of the threshold crossing after the first half cycle may have some phase delay, but the threshold crossing at the end of the second half cycle need not have any phase delay. In the case where the signal is used to generate useful timing information, for example in motor vehicle crank signal detection, a timing detection circuit can therefore work with just one set of the transitions not having a phase delay.

In the case where one half cycle is more prone to noise, for example, if that half cycle has a lower slope, then the full hysteresis may be used with this half cycle.

In a preferred embodiment of the invention, the hysteresis means generates a signal that is added to a comparator input signal upon the crossing by the comparator means of a threshold. The hysteresis signal may then decay prior to the subsequent threshold crossing to allow the comparator means output again to switch, so that over a first half cycle of the oscillating signal the hysteresis signal decays partially, and over a subsequent second half cycle of the oscillating signal the hysteresis signal decays fully so as not to affect the threshold level, and thereby introduce a phase delay.

Often, it may be the case that in the absence of a hysteresis signal, for example after full decay of the second half cycle hysteresis signal, the threshold level is a mean level of the oscillating signal or thereabouts.

The frequency of the oscillating signal may be variable, in which case the hysteresis may have a variable decay rate to match the variable period of the half cycles. It is, however, also possible that the hysteresis signal has a peak level prior to the decay of said signal that is dependent on the period between threshold crossings. Then, although a decay time constant may be fixed, it is possible by moving the level of the second half cycle hysteresis signal up or down, to ensure that the hysteresis signal during the second half cycle has fully decayed prior to the subsequent expected threshold crossing.

In the case where the signal is essentially sinusoidal with a mean level, for example zero volts, the hysteresis signal peak level in the second half cycle may be shifted relatively towards or away from said mean signal level when said period is respectively decreased or increased so that the hysteresis signal will decay fully over the second half cycle.

The hysteresis signal decay may be any type of decay that tends with sufficient time to a limit value, but is preferably an exponential type decay, since this matches the relationship between period and level of variable reluctance sensors.

The electronic circuit described above may be installed in a motor vehicle that has an engine and an engine speed sensing apparatus with an electrical output that provides an oscillating signal when the engine is turning. The engine speed sensing apparatus can then provide an oscillating signal comprising an essentially sinusoidal pulse train having a mean signal level and with at least one extended half cycle during each turn of the engine. The slope of the oscillating signal would then be reduced during the extended half cycle proximate the mean signal level. Consequently, the limit level associated with the hysteresis during the extended half cycle may be shifted relative to the mean level so as to avoid substantially most of the fluctuation in the comparator means output owing to noise.

Also according to the invention, there is provided a method of using hysteresis in an electronic circuit to discriminate in the presence of noise, threshold crossings of an oscillating signal having a mean level, the mean level defining alternating positive-going half cycles and negative-going half cycles, said circuit comprising: an input; a comparator means; an output from the comparator means; a means for providing said hysteresis; the method comprising the steps of:
i) supplying the oscillating signal having some noise to the input of the circuit;
ii) supplying to the comparator means a pair of comparator input signals, one or both of said signals being at least partially dependent on the oscillating signal, the difference between said input signals defining a threshold level;
iii) generating a hysteresis signal that upon switching of the comparator means rises alternately to a maximum positive magnitude and a maximum negative magnitude in alternate half cycles, and then decays thereafter in magnitude, the hysteresis on one half cycle decaying at a rate that would take the hysteresis to a first limit level and the hysteresis on an alternate half cycle decaying at a rate that would take the hysteresis to a second limit level;
iv) incorporating in one or both of said comparator input signals said hysteresis so that once the comparator means has switched between high and low said output does not fluctuate between high and low owing to the noise;
   characterised in that
   the hysteresis signal is generated so that the limit levels are shifted either both positively or both negatively with respect to the mean level of the oscillating signal, and so that the hysteresis decay is limited in half cycles in which the hysteresis is of the opposite sign to that of the limit levels.

The invention will now be further described by way of example, with reference to the accompanying drawings, in which:
Figure 1 is a drawing of a typical oscillating signal from a motor vehicle crank sensor, and of a digital signal produced from this signal;
Figure 2 is an expanded view of an actual crank sensor signal having noise, and of a digital signal that is used to schedule fuel injection, showing multiple erroneous transitions in the digital signal owing to the noise;
Figure 3 is a schematic representation of a prior art crank signal and hysteresis signal used discriminate in the presence of noise threshold crossings of an oscillating signal, but having variable phase delays on detected threshold crossings;
Figure 4 is a schematic representation similar to that of Figure 3, but showing a hysteresis signal according to the invention, which decays fully over one half cycle so that the subsequent threshold crossing does not have a variable phase delay;
Figure 5 is a schematic representation similar to that of Figure 4, but showing a hysteresis signal with an enhanced ability to discriminate in the presence of noise threshold crossings of an oscillating signal; and
Figures 6 and 7 are, respectively, simplified and full circuit diagrams of an electronic circuit according to the invention that uses a hysteresis signal similar to that of Figures 4 and 5 in order to discriminate in the presence of noise threshold crossings of an oscillating signal.

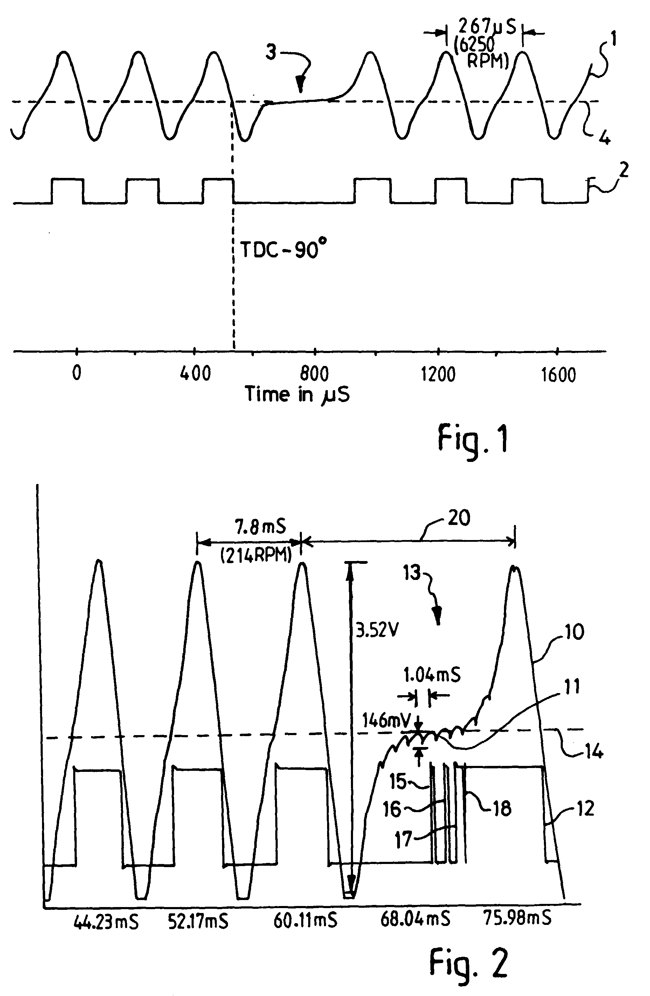

Figure 1 shows a typical oscillating signal 1 from a crank sensor, here a variable reluctance sensor (VRS) sensing the passage of teeth on a so-called "36 minus one" toothed wheel (not shown). One tooth is missing 3, so as to identify a known angular position of the engine, here 90° before top dead centre (TDC). A digitised buffered VRS signal 2 has been produced in a known way, having transitions between low and high levels at points in time corresponding to the crossings by the VRS signal 2 of a mean signal level 4. Apart from the missing tooth position 3, the period of the essentially sinusoidal VRS signal is 267 µs, implying an engine speed of 6250 rpm.

Figure 2 shows an actual VRS signal 10 at a low engine speed of 214 rpm, and a digital signal 12 derived from the crossings by the VRS signal 10 of a threshold 14. The signal has noise 11, which is more of a problem at lower engine speed because the amplitude of the VRS signal scales approximately linearly with engine speed. Here, the amplitude of the VRS signal 10 is 3.52 volts, compared with a noise amplitude of about 146 mV with a period of 1.04 ms.

The noise 11 does not cause any false transitions in the digital signal 12 except in the vicinity 13 corresponding to a missing tooth where the slope of the VRS signal 10 becomes low in proximity with the threshold 14. Here, there are three multiple false transitions 15,16,17 prior to a final transition 18 of the digital signal 12, at the end of an extended half cycle 20 corresponding to vicinity 13 of the missing tooth. Although not shown, with the same noisy VRS signal some false transitions were noted on normal teeth.

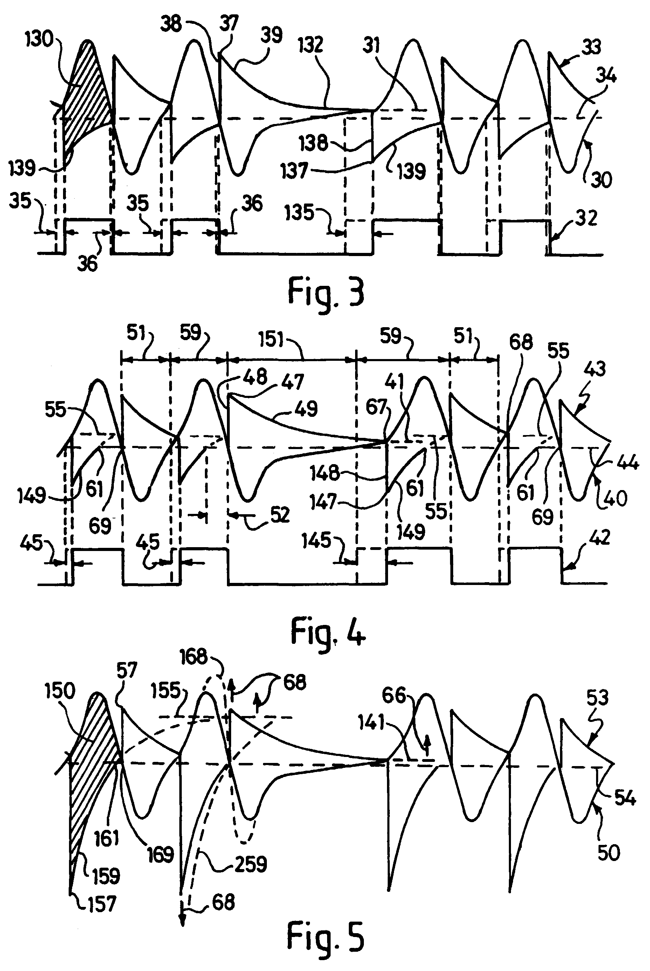

Figure 3 shows one way known in the prior art of preventing such multiple false transitions 15-17. Here, an oscillating VRS signal 30 having a mean signal level 34 is drawn superimposed on a hysteresis signal 33. A digital signal 32 has been generated from the oscillating VRS signal 30. The hysteresis signal 33 has a number of sharp positive-going transitions 38 or negative-going transitions 138, with opposite slope to the VRS signal 30 at the points where the VRS signal and hysteresis signal 33 cross. Once the hysteresis signal 33 has reached a peak positive magnitude 37 or peak negative magnitude 137, it decays exponentially with a negative slope 39 or a positive slope 139.

The area between the oscillating signal 30 and the hysteresis signal 33, part of which is shown hashed 130, is a measure of the immunity to noise provided by the hysteresis 33.

Given sufficient time, the hysteresis signal would decay fully to a limit level. In the case of the positive slope decay 139 the limit level towards which the hysteresis signal decays from the peak negative magnitude 137 is the mean level 34. In the case of the negative slope decay 39, the limit level is a level 31 above the mean level 34 so that the hysteresis signal 33 decays only partially back to the threshold level 34 and cannot reach this mean level before the VRS signal 30 makes the subsequent crossing of the hysteresis signal 33. The raised limit level 31 provides increased immunity to noise in a region 132 of low slope of the oscillating signal corresponding to a missing tooth as described above.

An electronic circuit (not shown) is gated by the hysteresis signal 33 in such a way that a transition in the digital signal 32 is inhibited until the VRS signal 30 has crossed the threshold 34 and then exceeded the magnitude of the hysteresis signal 33. This has the side effect of introducing phase delays 35,36,135 in the digital signal 32. Because the positive slope decay 139 has a limit value of the mean signal level 34, the phase delay 36 associated with the next crossing of the oscillating signal 30 and hysteresis signal is smaller than the phase delay 35,135 associated with the negative slope decay 39.

Figure 4 shows an oscillating VRS signal 40 and a hysteresis signal 43 according to the invention. Here the oscillating signal 40 is the same as the VRS signal of Figure 3, and the hysteresis signal 43 has a similar shape and effect to that described above during negative-going half cycles 51 of an oscillating signal 40. The negative-going half-cycles include one extended negative-going half cycle 151 owing to a missing tooth. During the negative-going half cycles 51,151, the hysteresis signal 43 rises rapidly 48 to a maximum positive magnitude 47, and then decays exponentially 49 with a negative slope to a first limit level 41, raised above a mean threshold level 44. During positive-going half cycles 59 of the oscillating signal 40, the hysteresis signal falls rapidly 148 to a maximum negative magnitude 147, and then decays exponentially 149 with a positive slope at a rate that would take the hysteresis signal to a second limit level 55.

The second limit level 55 is set with a greater magnitude than the first limit level 41. Prior to reaching the second limit level 55, the hysteresis signal 43 reaches the mean signal level 44 at a point 61, at which point the hysteresis signal 43 is limited or truncated so that the hysteresis signal remains nominally zero at the mean level 44 until the next crossing of the oscillating signal 30 and the hysteresis signal 43.

During negative-going half cycles 51,151, the rising oscillating signal 40 crosses the hysteresis signal 43 at points 67,68, raised above the mean level 44. During positive going half cycle 59, the oscillating signal 40 crosses the hysteresis signal 43 at points 69 at the mean level 44.

As will be explained in more detail below, the crossing between the oscillating signal 40 and hysteresis signal may be used to generate a digital signal 42. This digital signal 42 will have a phase delay 45,145 as in the prior art owing to the signal crossings at the raised points 67,68, but these crossing need not be used to generate engine timing information.

As a result of the nominally zero hysteresis signal following point 41, there is no phase delay at signal crossing point 69 where the falling oscillating signal 40 crosses the mean level 44. In a motor vehicle, this has a significant benefit, because it is the falling edge of the VRS signal which is known to be accurate, and from which all engine timing signals should ideally be derived. There will, of course, be some noise in the VRS signal, but because of the relatively high slope of the falling VRS signal as it crosses the mean level 44, the effect of noise between points 61 and point 69 is less than for a signal with a relatively smaller slope.

Figure 5 illustrates how the invention may be used to improve noise immunity whilst at the same time avoiding phase shifts detected on alternate cycles of an oscillating signal 50, having a mean level 54. A hysteresis signal 53 is drawn superimposed on the oscillating signal 50. The hysteresis maximum positive magnitude 57 is the same as that illustrated in Figure 4, but the maximum negative magnitude 157 of the hysteresis signal has been increased. Because the hysteresis signal does not decay to the mean level as in the prior art shown in Figure 3, it is possible to increase also the magnitude of the limit level 155 so that the hysteresis signal still decays to the mean level 54 at a point 161 prior to a crossing of the mean level by the oscillating signal at a point 169. By appropriate choice of maximum magnitude, decay rate and limit value, it is possible to increase significantly the area 150 between the hysteresis signal 53 and oscillating signal 50. In particular, a larger vertical separation, in practice a larger voltage difference, between the hysteresis and oscillating signals can be maintained until shortly before an expected crossing of the hysteresis signal 53 and oscillating signal 50. This provides increased noise immunity.

As mentioned above, the VRS signal amplitude will increase with increased frequency. Therefore, the magnitude of the hysteresis signal 53, including optionally the magnitude of one or both limit levels 141,155 may be increased, as shown by arrows 66, for an increase in the frequency and amplitude of the oscillating signal, as shown by dashed line 166. In addition, the rate of decay 259 of the hysteresis on one or both half cycles may be increased in order to accommodate for the shorter period.

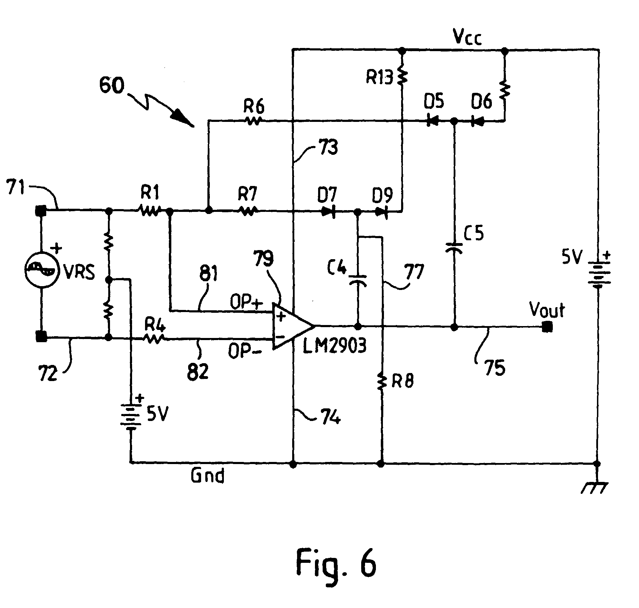

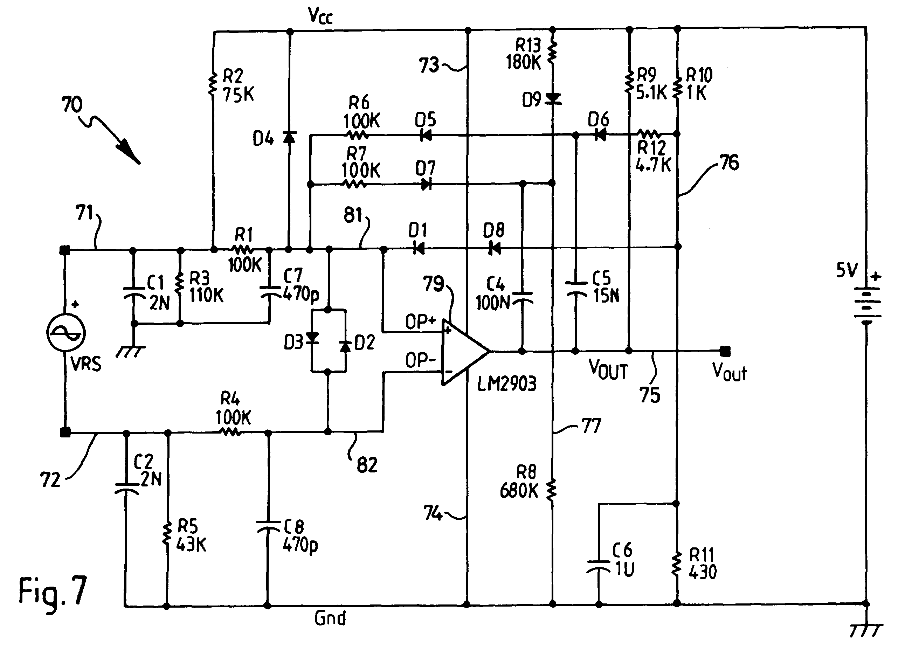

Circuitry will for putting the invention into effect will now be described with reference to Figures 6 and 7.

Figure 6 shows a simplified circuit diagram 60, and Figure 7 shows a full circuit diagram 70, of a circuit that generates such a hysteresis signal, in response the threshold crossings of a VRS signal, and gives as an output a digital signal with no phase delay on the threshold crossings detected on the falling edges of the VRS signal.

The circuits 60,70 work in the following way. An input signal VRS is connected to input lines 71,72 which run via filters respectively to input lines 81,82 connected to the inputs OP+, OP- of an LM2903 series comparator 79. The comparator 79 is connected to dc power lines Vcc at 5 volts and Gnd at zero volts along, respectively, lines 73 and 74 and generates an output voltage Vout on an output line 75.

The positive input line 71 includes filters R1,C7, and R3,C1, and the negative input line 72 includes a filter R4,C8. Because the VRS signal peak-to-peak voltages vary with frequency, the VRS input signal maximum voltage at the comparator 79 is clamped by back-to-back diodes D2 and D3 spanning input lines 81,82. This also improves accuracy by causing the inherent phase delay from the filters R1,C7 and R4,C8 to take effect only after the signal comes 'in range', that is within the clamped voltage range.

The LM2903 comparator inputs OP+,OP- can go to +30 volts without harm. In the negative direction, less than - 0.3 volts causes high currents to flow internally through the comparator 79. Two diodes D1 and D8 and forwards connected to the comparator positive input OP+ from a 1.5 volt source defined along a line 76 by resistors R10 and R11 splitting the dc supply Vcc. This provides a negative going clamp to the comparator positive input OP+ at 0.3 volts and the comparator negative input OP- at -0.3V through diode D3. Capacitor C6 in parallel across resistor R11 to ground line Gnd is used to prevent a low impedance transient pulling the 1.5 volt reference voltage low, and hence the comparator inputs OP+ and OP- out of range. An equivalent clamp operates on the OP- input through a parallel resistor R5 and capacitor C2.

A maximum available common mode range for the comparator 79 is provided in the following way: the clamps mentioned above limit the minimum voltage of at least one input to 0.3 V (1.5 V minus the diode D2,D3 drops), and these also limit the maximum of at least one input to 2.7 V (1.5 V plus two diode drops). By clamping the comparator inputs OP+ and OP- close to the allowable VCM range, typically 0 to 3 volts, (Vcc minus 2 V), the maximum range of common mode signals can be presented to, and rejected by the comparator. This maximises the noise rejection ability of common mode noise.

The pair of comparator inputs OP+,OP- have independent input filters using resistors R1,R4 and capacitors C7,C8. This has the advantage over a filter directly between the two comparator inputs OP+,OP-, because this rejects common mode spikes, such as spark interference, as well as differential noise spikes.

A time dependent hysteresis level is provided in the following way. During a first half cycle when the VRS signal is going below threshold, positive feedback for comparator 79 is provided by a resistor R6 and capacitor C5 in series via forward connected diode D5 between the comparator output line 75 and comparator positive input line 81, whenever the comparator output voltage Vout is high. This produces a hysteresis level which starts high and falls off exponentially with an RC time constant, and which has been selected to decay sufficiently quickly so that even a signal having the minimum expected VRS peak-to-peak voltage can be discriminated near the actual threshold crossing. The design limit in this case was taken to be a signal at 300 Hz where the exponential decay hysteresis level has its closest approach to the 1/x amplitude function of the variable reluctance sensor. This is one feature that helps the circuit to reject noise: it takes advantage of the fact that the variable reluctance sensor output rises nearly linearly with frequency, especially at a low end of frequency.

The hysteresis level during the first half cycle, when the VRS signal is falling and the comparator output Vout is high, is applied from the charge on capacitor C5 via resistor R6 and diode D5. The inclusion of diode D5 prevents this hysteresis being applied during the second half cycle when the comparator output is low. During this latter period, the capacitor C5 is recharged for the 'third' half cycle (and so on) via a current limiting resistor R12 and forwards connected diode D6, connected to the voltage clamped line 76. Resistor R12 allows the comparator output Vout to fall quickly (less than a microsecond), which would not otherwise be the case due to the loading of capacitor C5.

During a second half cycle when the VRS signal is going above threshold, positive feedback for the LM2903 comparator 79 is provided by a resistor R7 and capacitor C4 in series via reverse connected diode D7 between the comparator output line 75 and comparator positive input line 81, whenever the comparator output voltage Vout is low. This produces a hysteresis level which starts low and rises exponentially with an RC time constant, and which has been selected to decay sufficiently quickly.

The junction between diode D7 and capacitor C4 is connected to a line 77 clamped at 3.6 volts by a pair of voltage dividing series resistors R13 and R8 spanning the power lines Vcc and Gnd, including a 0.3 volt drop across a forwards connected diode D9 between the resistors R13 and R8.

The hysteresis level during the second half cycle is applied from the charge on capacitor C4 via resistor R7 and diode D7. At the same time, this capacitor C4 is also charged via resistor R13 and diode D9. By charging from the 5 volt dc power line Vcc via resistor R13, the voltage on capacitor C4 is caused to rise above the 1.5 volt mid-point of the incoming signal. When this happens, the reverse connected diode D7 blocks any hysteresis effect. The timing of this is designed to occur before the next accurate crossing edge is due.

The discharge path of capacitor C4 is via resistor R8 alone. This causes a difference in charge to discharge ratio, which results in an average stage of charge of capacitor C4 that varies with signal frequency. This permits the hysteresis state described above to be maintained over a wide range of frequencies: as the frequency rises, so does the average voltage on capacitor C4. Thus the time it takes to charge above the 1.5 volt reduces. Capacitor C4 can only apply hysteresis by charging, and only to the extent that it discharged in the previous period. Consequently, the time during which hysteresis is applied reduces, and the cause of this is that the time between cycles reduces. This maintains the operation whereby the hysteresis is no longer present when the accurate edge of the incoming signal crosses the mid-point threshold.

Noise protection is given by the hysteresis levels, since the signal is required to exceed these in magnitude before switching of the output will occur.

The charge/discharge arrangement on capacitor C4 has the effect at higher frequencies of reducing the amount of hysteresis available to prevent false transitions on the positive going slope of the VRS signal. However, this is not a problem because the VRS signal is larger at higher frequencies so that the signal-to-noise ratio is higher.

The circuit and method described above for discriminating in the presence of noise, threshold crossings of an oscillating signal, is particularly useful as applied to a motor vehicle crank signal where noise can be a problem. The circuit, however, may be used in any application where a phase delay owing to hysteresis is undesirable on one or both slopes of an oscillating signal.

## Claims

1. An electronic circuit (70) for discriminating in the presence of noise (11), threshold crossings (67,68,69) of an oscillating signal (40,50) having a mean level (44,54), the mean level (44,54) defining alternating positive-going half cycles (59) and negative-going half cycles (51,151), the circuit (70) comprising: an input (71,72) for said oscillating signal (40,50); a comparator means (79) having a pair of comparator inputs (OP+,OP-); an output (75) from the comparator means (79) that switches between high and low upon a threshold crossing (67,68,69); means for providing hysteresis (43,53) so that once the comparator means (79) has switched between high and low said output (75) does not fluctuate between high and low owing to the noise (11); wherein the pair of comparator inputs (81,82) are each provided with an input signal, one or both of said signals incorporating said hysteresis (43,53) and being at least partially dependent on the oscillating signal (40,50), the difference between said input signals defining a threshold level at which the comparator means (79) switches, the hysteresis (43,53) upon switching of the comparator means (79) rising (48,148) alternately to a maximum positive magnitude (47,57) and a maximum negative magnitude (147,157) in alternate half cycles (51,151;59), and then decaying (49,149,159,259) thereafter in magnitude, the hysteresis (43,53) on one half cycle (51,151) decaying (49) at a rate that would take the hysteresis (43,53) to a first limit level (41,141) and the hysteresis (43,53) on an alternate half cycle (59) decaying (149,159,259) at a rate that would take the hysteresis (43,53) to a second limit level (55,155), characterised in that the limit levels (41,141;55,155) are shifted either both positively or both negatively with respect to the mean level (44,54) of the oscillating signal (40,50), and in that the circuit (70) comprises means to limit (61,161) the decay in the hysteresis (43,53) during half cycles (59) in which the hysteresis (43,53) is of the opposite sign to that of the limit levels (41,141;55,155).

2. An electronic circuit (70) as claimed in Claim 1, in which the limit level (55,155) associated with the hysteresis (43,53) having the limited decay (149,159,259) is of greater positive or negative magnitude than the other limit level (41,141).

3. An electronic circuit (70) as claimed in Claim 1 or Claim 2, in which in the absence of hysteresis (43,53), the threshold level is a mean level (44,54) of the oscillating signal (40,50).

4. An electronic circuit (70) as claimed in any preceding claim, in which the means for providing hysteresis (43,53) includes means by which the hysteresis maximum magnitude (157) is dependent (66) on the period between threshold crossings (67,68,69).

5. An electronic circuit (70) as claimed in any preceding claim, in which the means for providing hysteresis (43,53) includes means by which the limit level (155) associated with the limited decay (159,169) is dependent (66) on the period between threshold crossings (67,68,69).

6. An electronic circuit (70) as claimed in any preceding claim, in which the means for providing hysteresis (43,53) includes means by which the decay rate (159,259) of the hysteresis (43,53) is dependent (66) on the period between threshold crossings (67,68,69).

7. An electronic circuit (70) as claimed in any preceding claim, in which the hysteresis signal decay (49,149,159,259) is an exponential type decay.

8. A motor vehicle, comprising an engine, an engine speed sensing apparatus with an electrical output that provides an oscillating signal (40,50) when the engine is turning, and an electronic circuit (70) arranged to receive the oscillating signal (40,50), in which the electronic circuit (70) is as claimed in any preceding claim.

9. A method of using hysteresis (43,53) in an electronic circuit (70) to discriminate in the presence of noise (11), threshold crossings (67,68,69) of an oscillating signal (40,50) having a mean level (44,54), the mean level (44,54) defining alternating positive-going half cycles (59) and negative-going half cycles (51,151), said circuit (70) comprising: an input (71,72); a comparator means (79); an output (75) from the comparator means (79); a means for providing said hysteresis (43,53); the method comprising the steps of:
i) supplying the oscillating signal (40,50) having some noise (11) to the input (71,72) of the circuit (70);
ii) supplying to the comparator means (79) a pair of comparator input signals, one or both of said signals being at least partially dependent on the oscillating signal (40,50), the difference between said input signals defining a threshold level;
iii) generating a hysteresis signal (43,53) that upon switching of the comparator means (79) rises (48,148) alternately to a maximum positive magnitude (47,57) and a maximum negative magnitude (147,157) in alternate half cycles (51,151;59), and then decays (49,149,159,259) thereafter in magnitude, the hysteresis (43,53) on one half cycle (51,151) decaying (49) at a rate that would take the hysteresis (43,53) to a first limit level (41,141) and the hysteresis (43,53) on an alternate half cycle (59) decaying (149,159,259) at a rate that would take the hysteresis (43,53) to a second limit level (55,155);
iv) incorporating in one or both of said comparator input signals said hysteresis (43,53) so that once the comparator means (79) has switched between high and low said output (75) does not fluctuate between high and low owing to the noise (11);
characterised in that
the hysteresis signal (43,53) is generated so that the limit levels (41,141;55,155) are shifted either both positively or both negatively with respect to the mean level (44,54) of the oscillating signal (40,50), and so that the hysteresis decay is limited (61,161) in half cycles (59) in which the hysteresis (43,53) is of the opposite sign to that of the limit levels (41,141;55,155).
